# EUROPÄISCHE PATENTSCHRIFT

(11) **EP 4 376 059 B1**
(45) Veröffentlichungstag und Bekanntmachung des Hinweises auf die Patenterteilung: **17.09.2025**
(21) Anmeldenummer: 23208661.1
(22) Anmeldetag: 08.11.2023
(51) Int. Cl.: H01L 21/677

(54) **ENTLADEEINRICHTUNG FÜR EIN SUBSTRATMAGAZIN, SUBSTRATMAGAZINSYSTEM**
DISCHARGING DEVICE FOR A SUBSTRATE MAGAZINE, SUBSTRATE MAGAZINE SYSTEM
DISPOSITIF DE DÉCHARGEMENT POUR UN MAGASIN DE SUBSTRATS, SYSTÈME DE MAGASIN DE SUBSTRATS

(30) Priorität: 09.11.2022 DE 102022129638
(43) Veröffentlichungstag der Anmeldung: 29.05.2024
(73) Patentinhaber: ASYS Automatisierungssysteme GmbH, 89160 Dornstadt (DE)
(72) Erfinder: Glaß, Markus, 88480 Achstetten (DE); Matthias, Baiker, 89269 Vöhringen (DE); Strehl, Alexander, 89155 Dellmensingen (DE)
(74) Vertreter: Clarenbach, Carl-Philipp

(56) Entgegenhaltungen:
- DE-A1- 102019 217 033
- DE-A1- 19 602 297
- US-A1- 2005 089 388

## Beschreibung

Die Erfindung betrifft eine Entladeeinrichtung für ein Substratmagazin, wobei das Substratmagazin mehrere Schubfächer aufweist, in welchen Substrate zur Lagerung oder Zwischenlagerung anordenbar sind, mit zumindest einem ansteuerbaren Transportband, auf welchem die Substrate ablegbar sind, mit zumindest einem ansteuerbaren Greifarm, der dazu ausgebildet ist, zumindest ein Substrat aus einem Schubfach des Substratmagazins auf das Transportband herauszuschieben, wobei das Transportband und der Greifarm an einem gemeinsamen und beweglich gelagerten Träger angeordnet sind, wobei der Greifarm zumindest in einer Ausgangsstellung unterhalb des Transportbands angeordnet ist, um zumindest ein Substrat von unten zu greifen.

Weiterhin betrifft die Erfindung ein Substratmagazinsystem für eine Bestückungslinie von flächigen Substraten, mit zumindest einem Substratmagazin, das mehrere Schubfächer aufweist, in welchen Substrate zur Lagerung oder Zwischenlagerung anordenbar sind.

Entladeeinrichtungen der eingangs genannten Art sind aus dem Stand der Technik bekannt. So ist beispielsweise in der Offenlegungsschrift DE 10 2019 217 033 A1 eine gattungsgemäße Entladeeinrichtung beschrieben. Diese weist einen auf einem Träger gelagerten Greifarm auf, der in das Substratmagazin eingefahren werden kann, um ein Substrat aus einem Schubfach des Magazins herauszuziehen. Dazu weist der Greifarm an seinem freien und zuerst in das Magazin einzuschiebenden Ende einen umschwenkbaren Greiffinger auf, der beim Einschieben horizontal ausgerichtet ist, sodass er zwischen übereinander angeordnete Substrate oder Schubfächer eingeschoben werden kann, und im eingefahrenen Zustand um eine vertikale Position oder Ausrichtung verschwenkt wird, um beim Herausziehen des Greifarms ein Substrat aus dem Schubfach herauszuziehen beziehungsweise herauszuschieben, sodass es durch den Greifarm auf das Transportband geschoben wird.

Ist das Substratmagazin derart ausgebildet, dass auch ein Substratstapel mit mehreren direkt aufeinander aufliegenden Substraten in einem Schubfach anordenbar ist, kann der Greifarm nicht zwischen zwei aufeinander liegende Substrate eingefahren werden, und der Stapel kann immer nur von dem Greifarm insgesamt aus dem Substratmagazin herausgezogen werden. Die obengenannte Druckschrift sieht daher vor, einen zusätzlichen beweglichen Vakuum-Greifer als Vereinzelungseinrichtung vorzusehen, der dazu ausgebildet ist, ein Substrat in dem Substratmagazin von oben zu greifen und dadurch von dem Substratstapel abzuheben beziehungsweise zu vereinzeln und alleine beziehungsweise losgelöst vom Rest des Substratstapels, auf das Transportband abzulegen.

Der Erfindung liegt die Aufgabe zugrunde, eine verbesserte Entladeeinrichtung für ein Substratmagazin zu schaffen, die insbesondere einen geringeren Bauraumbedarf aufweist und eine weniger komplexe Aktuatorik, die zur Vereinzelung einsetzbar ist.

Die der Erfindung zugrunde liegende Aufgabe wird durch eine Entladeeinrichtung mit den Merkmalen des Anspruchs 1 gelöst. Diese hat den Vorteil, dass eine Vereinzelung eines Substratstapels ohne einen Vakuum-Greifer erfolgt, wobei die Vereinzelung in der Entladeeinrichtung erfolgt und nicht im Substratmagazin selbst, wodurch im Substratmagazin selbst kein Platz vorgehalten werden muss, der für einen Vakuum-Greifer zur Vereinzelung eines Substratmagazins ansonsten notwendig wäre.

Erfindungsgemäß ist hierzu vorgesehen, dass der Greifarm dazu ausgebildet ist, einen Substratstapel mit mehreren aufeinanderliegenden Substraten aus einem der Schubfächer oberhalb des Transportbandes herauszuschieben, dass oberhalb des Transportbandes eine Vereinzelungseinrichtung angeordnet ist, in welche der Substratstapel durch den Greifarm einschiebbar ist, und dass die Vereinzelungseinrichtung dazu ausgebildet ist, das unterste Substrat des Substratstapels von dem Substratstapel zu lösen und auf das darunterliegende Transportband abzulegen. Dadurch, dass erfindungsgemäß ein Substratstapel nach unten vereinzelt wird, also einzelne Substrate aus dem Substratstapel nach unten entnommen werden, ist eine besonders kompakte Lösung geboten, weil ein vereinzeltes Substrat direkt oder nahezu direkt auf das Transportband abgelegt werden kann. Dadurch ist sowohl die Aktuatorik der Entladeeinrichtung als auch der vorteilhafte Bauraum im Vergleich zu vorbekannten Lösungen deutlich kleiner.

Vorzugsweise weist die Vereinzelungseinrichtung zwei beabstandet zueinander angeordnete Führungswände auf, zwischen denen der Substratstapel vertikal geführt aufnehmbar ist. Durch die Führungswände wird erreicht, dass der Substratstapel zwischen den Führungswänden sicher gehalten ist und insbesondere in einer Form verbleibt. Ein Auseinanderschieben von den übereinanderliegenden Substraten wird durch die Führungswände verhindert. Vorzugsweise ist zumindest eine der Führungswände horizontal verlagerbar angeordnet, um den Abstand zwischen den Führungswänden an einen aufzunehmenden oder zwischen den Führungswänden aufgenommenen Substratstapel anzupassen. Dabei ist der zumindest einen Führungswand bevorzugt ein ansteuerbarer Aktuator zugeordnet, mittels dessen die Führungswand automatisiert verschoben werden kann. Insbesondere ist vorgesehen, dass nach dem Einführen eines Substratstapels in die Vereinzelungseinrichtung, die zumindest eine Führungswand auf die andere Führungswand zu bewegt wird, um den dazwischenliegenden Substratstapel auszurichten und gegebenenfalls verschobene Substrate des Substratstapels zusammenzuschieben.

Weiterhin ist bevorzugt vorgesehen, dass dem unteren Ende der Führungswände zwei beabstandet und parallel zueinander angeordnete Führungsschienen zugeordnet sind, auf welche ein Substratstapel derart zwischen den Führungswänden aufschiebbar ist, dass das unterste Substrat an zwei voneinander abgewandten Seitenrändern auf jeweils einer der Führungsschienen aufliegt. Die Schienen stehen dazu bevorzugt von der jeweiligen Führungswand in Richtung der gegenüberliegenden Führungswand vor, sodass ein Substrat beziehungsweise Substratstapel auf den Führungsschienen randseitig zwischen den Führungswänden ablegbar ist. Da die Substrate oder die Substratstapel dadurch nur randseitig gehalten sind, kann der Bereich zwischen den Führungsschienen für weitere Aktuatorik der Entladeeinrichtung, insbesondere für den Greifarm, genutzt werden.

Weiter ist bevorzugt vorgesehen, dass eine erste der Führungswände in einem Abstand von der ihr zugeordneten ersten Führungsschiene endet, der zumindest der Höhe des untersten Substrats entspricht, sodass das unterste Substrat in eine durch den Abstand gebildete Aufnahme zwischen erster Führungswand und erster Führungsschiene seitlich einschiebbar ist. Insbesondere ist der Abstand kleiner als die Gesamthöhe von zwei der aufeinanderliegenden Substrate, sodass durch die Führungswand verhindert wird, dass zwei Substrate gleichzeitig in die Aufnahme geschoben werden können. Bevorzugt ist der Abstand einstellbar, sodass die Be- und Entladeeinrichtung auf unterschiedliche Substrate beziehungsweise Substratstapel anpassbar ist. Dazu ist beispielsweise die Führungswand in der Höhe beziehungsweise vertikal verschiebbar gelagert, wobei der Führungswand dann bevorzugt ein ansteuerbarer Aktuator, insbesondere ein elektromotorischer, pneumatischer oder hydraulischer Aktuator zugeordnet ist, mittels dessen die Führungswand vertikal verschiebbar ist. Wird nun das unterste Substrat verschoben, wird gewährleistet, dass nur das unterste Substrat in die Aufnahme geschoben wird. Dadurch wird das unterste Substrat bereits von dem übrigen Substratstapel vereinzelt.

Vorzugsweise weist die Vereinzelungseinrichtung eine Aktuatorvorrichtung zum Verschieben des untersten Substrats in die Aufnahme auf, wobei die Tiefe der Aufnahme mindestens der Breite der Führungsschiene vor der zweiten Führungswand, also der gegenüberliegenden Führungsschiene vor der gegenüberliegenden Führungswand entspricht. Dadurch ist gewährleistet, dass das Substrat derart weit in die Aufnahme einschiebbar ist, dass es auf der gegenüberliegenden Seite nicht mehr durch die Führungsschiene gestützt wird. Sobald das Substrat in die Aufnahme ausreichend weit eingeschoben wurde, fällt es daher auf der Seite der zweiten Führungsschiene von dieser herunter in Richtung des Transportbandes. Dadurch löst sich das Substrat von dem Substratstapel zumindest bereichsweise. Ist die Höhe der Aufnahme ausreichend hoch, kann dies dazu führen, dass das Substrat auch aus der Aufnahme selbstständig insgesamt auf das Transportband herunterfällt.

Weiter ist bevorzugt vorgesehen, dass die Aktuatorvorrichtung dazu ausgebildet ist, das unterste Substrat in die Aufnahme über die zweite Führungsschiene hinaus einzuschieben. Vorzugsweise ist die erste Aktuatorvorrichtung der zweiten Führungswand und Führungsschiene zugeordnet und als Schiebevorrichtung ausgebildet. Dazu weist die Aktuatorvorrichtung vorzugsweise einen ansteuerbaren Aktuator und ein Aktuatorelement auf, das vorzugsweise als Schiebeplatte ausgebildet ist, die horizontal verschiebbar gelagert ist, um ein Substrat in Richtung der Aufnahme zu verschieben. Die Schiebeplatte ragt insbesondere durch eine Öffnung hindurch, die zwischen der zweiten Führungswand und der zweiten Führungsschiene gebildet ist.

Weiterhin ist bevorzugt vorgesehen, dass die Vereinzelungseinrichtung eine zweite Aktuatorvorrichtung aufweist, die dazu ausgebildet ist, das unterste Substrat aus der Aufnahme und über die erste Führungsschiene hinaus zu verschieben. Durch die zweite Aktuatorvorrichtung ist somit das einmal in die Aufnahme eingeschobene Substrat aus der Aufnahme wieder herausschiebbar. Weil das Substrat in diesem Moment bereits von der zweiten Führungsschiene gelöst ist und in Richtung des Transportbandes gefallen oder gekippt ist, wird durch das Zurückschieben aus der Aufnahme heraus erreicht, dass das Substrat nunmehr vollständig aus der Vereinzelungseinrichtung gelöst und auf das darunterliegende Transportband abgeworfen wird. Durch die zweite Aktuatorvorrichtung wird außerdem erreicht, dass der Abstand zwischen der ersten Führungswand und der ersten Führungsschiene nur geringfügig größer als die Höhe des aufzunehmenden Substrats ausgebildet sein muss, da selbst dann, wenn das Substrat, das auf der gegenüberliegenden Seite bereits in Richtung des Transportbands gekippt ist, in der Aufnahme verkantet, durch die Aktuatorvorrichtung das Substrat aus der Klemmung gelöst wird.

Vorzugsweise ist unter den Führungsschienen das zumindest eine Transportband in einem insbesondere vertikalen Abstand angeordnet, der größer ist als die Höhe des untersten Substrats. Dadurch ist gewährleistet, dass das unterste Substrat, das aus der Aufnahme heraus zurückgeschoben wird, vollständig unter die erste Führungsschiene geschoben werden kann, um von der zweiten Führungsschiene gelöst zu werden.

Weiterhin ist bevorzugt vorgesehen, dass die Vereinzelungseinrichtung derart ausgebildet ist, dass das unterste Substrat durch das Verschieben mittels der ersten und/oder zweiten Aktuatorvorrichtung direkt auf das zumindest eine Transportband fällt. Dadurch ist die Einrichtung in der Höhe besonders kompakt abbaubar.

Gemäß einer weiteren Ausführungsform der Erfindung sind bevorzugt zwei Transportbänder parallel und beabstandet zueinander angeordnet, wobei jeweils eines der Transportbänder einer der Führungsschienen zugeordnet ist. Dadurch ist für jede der Führungsschienen jeweils ein Transportband vorhanden, auf welches das jeweilige Substrat von der jeweiligen Führungsschiene fallen kann. Damit ist ein sicherer Abtransport und eine sichere Aufnahme des jeweiligen Substrats gewährleistet.

Weiterhin ist bevorzugt vorgesehen, dass gemäß einer weiteren Ausführungsform der Erfindung an dem Träger zumindest eine Stützschiene angeordnet und in der Höhe verfahrbar ausgebildet ist, um zwischen den Führungsschienen in einer Annahmestellung oberhalb der Transportebene des oder der Transportbänder und unterhalb der Führungsschienen zu liegen, sodass das unterste Substrat beziehungsweise das aus der Aufnahme herausgeschobene Substrat auf die Stützschiene fällt, und in einer Ablagestellung unterhalb der Transportebene, sodass beim Verfahren der Stützschiene in die Ablagestellung das Substrat auf der Transportebene beziehungsweise dem oder jeweiligen Transportband abgelegt wird. Mittels der Stützschiene wird somit der Abstand zu den Führungsschienen reduziert und damit die Fallhöhe des vereinzelten Substrats. Dadurch wird beispielsweise erreicht, dass empfindliche Substrate beim Herunterfallen auf das Transportband nicht brechen oder beschädigt werden können. Vielmehr fängt die Stützschiene das Substrat nahe zu der Stützschiene auf und legt es erst anschließend auf die tiefer liegende Transportebene des Transportbands ab.

Vorzugsweise ist der Träger in der Höhe verfahrbar ausgebildet. Dadurch werden Stützschiene und Greifarm bei Bedarf in der Höhe beziehungsweise vertikal verschoben, um einen sicheren Transport und ein vorteilhaftes Vereinzeln eines Substratstapels zu ermöglichen. Insbesondere wird dadurch erreicht, dass mittels des Greifarms ein Substratstapel vollständig in die Vereinzelungseinrichtung einschiebbar ist und anschließend ein Vereinzeln der Substrate nach unten durch ausreichend Freiraum unterhalb des Substratstapels bei heruntergefahrenem Träger gewährleistet ist.

Gemäß einer bevorzugten Weiterbildung der Erfindung ist die zumindest eine Stützschiene der zweiten Führungsschiene zugeordnet, liegt also nahe zu der zweiten Führungsschiene in Entladeeinrichtung beziehungsweise in der Vereinzelungseinrichtung. Dadurch wird das zuerst herausgeschobene Ende beziehungsweise die Seite des vereinzelten beziehungsweise untersten Substrats, das zuerst von der zweiten Führungsschiene nach unten fällt, durch die Stützschiene aufgefangen und die Fallhöhe vorteilhaft reduziert. Wenn anschließend das Substrat auf der gegenüberliegenden Seite aus der Aufnahme und über die erste Führungsschiene hinausgeschoben wird, ist das Substrat bereits durch die Stützschiene auf der gegenüberliegenden Seite gestützt und dadurch die Belastung, die auf das fallende Substrat beim Auftreffen auf das Transportband unterhalb der ersten Führungsschiene erfährt, derart reduziert, dass eine Beschädigung des Substrats verhindert ist. Optional wird auch der ersten Führungsschiene eine zusätzliche Stützschiene zugeordnet, um die Fallhöhe auch auf der Seite der ersten Führungsschiene zu reduzieren.

Das erfindungsgemäße Substratmagazinsystem mit den Merkmalen des Anspruchs 14 zeichnet sich durch die erfindungsgemäße Entladeeinrichtung aus. Es ergeben sich hierdurch die oben bereits genannten Vorteile. Vorzugsweise weist das Substratmagazinsystem mehere Substratmagazine auf, die durch die Entladeeinrichtung entladen werden können. Dazu ist der Träger der Entladeeinrichtung insbesondere auch horizontal verschiebbar, um die mehreren Substratmagazine erreichen zu können. Weitere Vorteile und bevorzugte Merkmale und Merkmalskombinationen ergeben sich insbesondere aus dem zuvor Beschriebenen sowie aus den Ansprüchen.

Im Folgenden soll die Erfindung anhand der Zeichnungen näher erläutert werden. Dazu zeigen
- **Figur 1**: ein Substratmagazinsystem in einer perspektivischen Darstellung,
- **Figur 2**: das Substratmagazinsystem in einer Draufsicht,
- **Figur 3**: eine Entladeeinrichtung des Substratmagazinsystems in einer perspektivischen Detaildarstellung,
- **Figur 4**: einen ersten Teil der Entladeeinrichtung in einer perspektivischen Detaildarstellung,
- **Figur 5**: einen zweiten Teil der Entladeeinrichtung in einer perspektivischen Detaildarstellung,
- **Figur 6**: den ersten Teil der Entladeeinrichtung in einer weiteren perspektivischen Detaildarstellung, und
- **Figur 7**: eine Seitenansicht der Entladeeinrichtung.

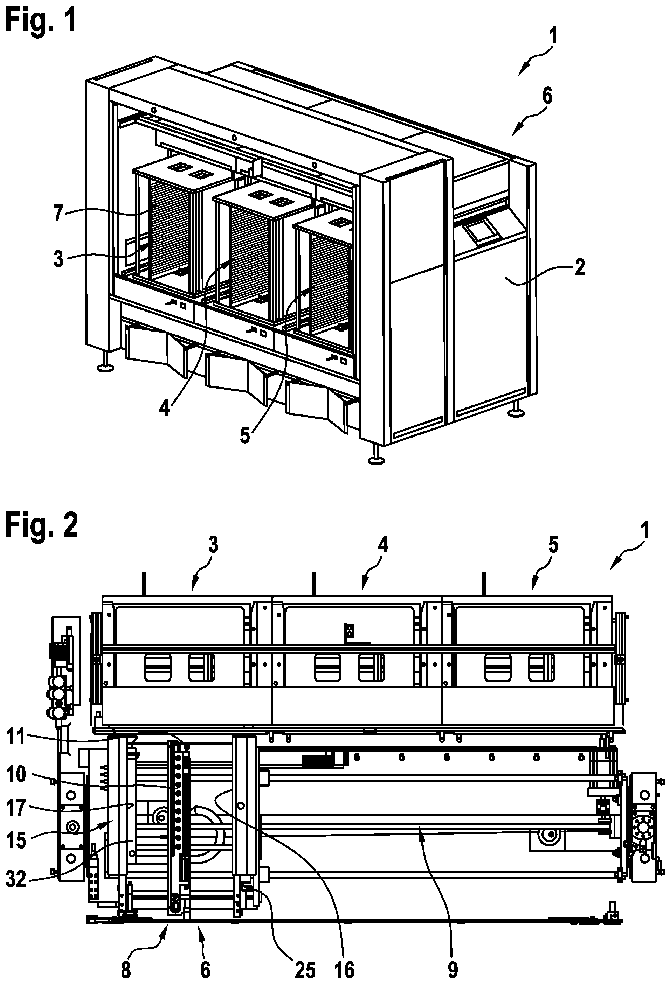

**Figur 1** zeigt ein Substratmagazinsystem 1 in einer vereinfachten perspektivischen Darstellung. Das Substratmagazin 1 ist dazu ausgebildet, in eine Bestückungslinie eingesetzt zu werden, um der Bestückungslinie Substrate, insbesondere Leiterplatten, Solarzellen oder Wafer, zuzuführen, die dann auf der Bestückungslinie beispielsweise bedruckt und/oder bestückt werden. Das Substratmagazinsystem 1 weist dazu ein Gehäuse 2 auf, in welchem mehrere, vorliegend drei Substratmagazine 3, 4, 5, sowie eine Entladeeinrichtung 6, die optional auch zum Beladen der Substratmagazine ausgebildet oder einsetzbar ist, angeordnet sind. Die Substratmagazine 3, 4, 5 sind nebeneinander angeordnet und weisen jeweils eine Vielzahl von Schubfächern 7 auf, die parallel übereinanderliegend angeordnet und ausgerichtet sind. In jedem Schubfach ist ein einzelnes, flächiges beziehungsweise flaches Substrat und/oder ein Substratstapel aufnehmbar. Ein Substratstapel zeichnet sich durch eine Vielzahl von direkt aufeinander aufliegenden Substraten aus. Je nach Größe der Schubfächer 7 und der Substrate ist nur ein einzelnes Substrat oder ein Substratstapel aufnehmbar. Wobei in den Schubfächern, in denen ein Substratstapel aufnehmbar ist, selbstverständlich auch ein einzelnes Substrat angeordnet werden kann.

Das Substratmagazinsystem 1 dient dazu, die Substrate zu lagern oder zwischenzulagern, bevor sie der Bestückungslinie automatisiert zugeführt werden. Die Substratmagazine 3, 4, 5 können dabei manuell oder automatisiert beispielsweise von der in Figur 1 gezeigten Rückseite beladen werden. Eine Rückwand ist zur Veranschaulichung in Figur 1 nicht gezeigt, sodass die Substratmagazine 3, 4, 5 erkenntlich sind. Optional ist in der Rückwand eine Tür oder ist die Rückenwand insgesamt als Tür ausgebildet, um ein einfaches Beladen der Substratmagazine von der Rückseite her zu ermöglichen.

**Figur 2** zeigt das Substratmagazinsystem 1 in einer vereinfachten Draufsicht, wobei das Gehäuse 2 nicht gezeigt ist. Die in dem Gehäuse 2 angeordnete Entladeeinrichtung 6 weist einen Träger 8 auf, der auf einem Schienensystem 9 horizontal verschiebbar gelagert ist, um in eine Gegenüberstellung zu jedem der Substratmagazine 3, 4, 5 geschoben werden zu können

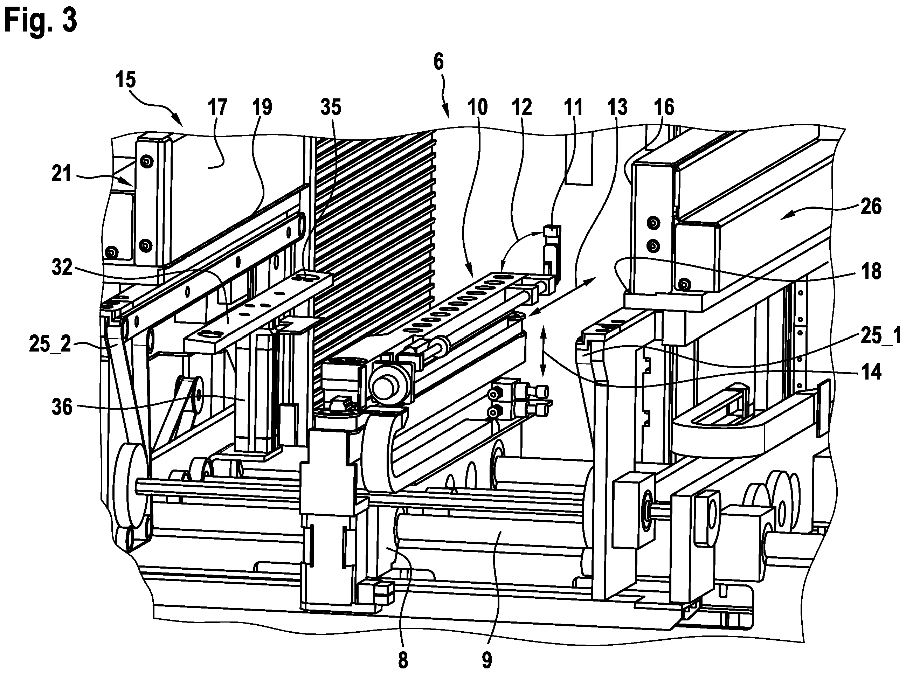

In **Figur 3** ist die Entladeeinrichtung 6 in einer vergrößerten perspektivischen Detailansicht gezeigt. Die Entladeeinrichtung 6 weist den bereits genannten Träger 8 auf, der auf dem Schienensystem 9 längsverschieblich gelagert ist. Auf dem Träger 8 ist ein Greifarm 10 angeordnet, der einendig einen verschwenkbaren Greiffinger 11 aufweist. Der Greiffinger 11 ist um eine horizontale Achse verschwenkbar gelagert, wie durch einen Doppelpfeil 12 gezeigt. Der Greifarm 10 ist längsverschieblich quer zur Schieberichtung des Trägers 8 gelagert, wie durch einen weiteren Doppelpfeil 13 angezeigt, um in eines der Substratmagazine 3, 4, 5, vor welchem sich der Träger 8 in dem Moment befindet, eingeschoben werden zu können. Außerdem ist der Träger 8 oder der Greifarm 10 in der Höhe verfahrbar, wie durch einen Doppelpfeil 14 angezeigt. Vorzugsweise ist der Träger 8 zusätzlich insgesamt in der Höhe verfahrbar, um die Entnahmeeinrichtung 6 auf eine Höhe verfahren zu können, in welcher ein Substrat oder Substratstapel in dem Substratmagazin 3, 4, 5 gelagert ist, um dieses/diesen mittels des Greifarms 10 herausschieben zu können.

Zum Herausschieben eines Substrats oder Substratstapels wird zunächst der Greifarm 10 mit in die horizontale Ausrichtung verschwenktem Greiffinger 11 unter das zu entnehmende Substrat oder unter den zu entnehmenden Substratstapel geschoben. Sobald der Greifarm 10 vollständig unter das Substrat beziehungsweise das unterste Substrat des Substratstapels geschoben ist, wird der Greiffinger 11 in die in Figur 1 gezeigte vertikale Ausrichtung verschwenkt und der Greifarm 10 wird zurück aus dem Substratmagazin 3, 4, 5 herausgezogen. Dabei wird das Substrat oder der Substratstapel durch den Greiffinger 11 mit aus dem Substratmagazin 3, 4, 5 herausgezogen beziehungsweise geschoben.

Die Entladeeinrichtung 6 weist weiterhin eine Vereinzelungseinrichtung 15 auf, die dazu dient, einen durch den Greifarm 10 aus dem Substratmagazin 3, 4 oder 5 herausgeschobenen Substratstapel zu vereinzeln, so dass einzelne Substrate des Substratstapels der Bestückungslinie zugeführt werden.

Dazu weist die Vereinzelungseinrichtung 15 zwei Führungswände 16 und 17 auf, die beabstandet zueinander angeordnet und parallel zueinander ausgerichtet sind, um zwischen sich einen Substratstapel aufnehmen zu können. Zumindest eine der Führungswände 16 und/oder 17 ist dabei horizontal verschiebbar gelagert, um eine Anpassung des Abstandes an den aufzunehmenden Substratstapel vornehmen zu können. Durch die Führungswände 16, 17 ist der Substratstapel zwischen den Führungswände 16, 17 sicher gehalten und ausgerichtet.

Die Vereinzelungseinrichtung 15 weist weiterhin eine erste Führungsschiene 18 und eine zweite Führungsschiene 19 auf, die parallel zueinander ausgerichtet und beabstandet zueinander angeordnet sind. Die erste Führungsschiene 18 ist unterhalb der Führungswand 16 und die zweite Führungsschiene 19 unterhalb der Führungswand 17 angeordnet. Dabei sind die Führungsschienen 18, 19 jeweils dem unteren Ende der jeweiligen Führungswand 16, 17 zugeordnet, wobei die Führungswände 16, 17 beabstandet zu den Führungsschienen 18, 19 enden. Die Führungsschienen 18, 19 stehen jeweils von der Führungswand 16, 17 in Richtung der gegenüberliegenden Führungswand 17, 16 vor und dienen somit als Auflage für ein Substrat oder für das unterste Substrat des Substratstapels. Dieser wird durch den Greifarm 10 aus dem Substratmagazin 3, 4 oder 5 auf die Führungsschienen 18, 19 zwischen den Führungswänden 16, 17 aufgeschoben, wobei das unterste Substrat des Substratstapels dann nur randseitig auf den Führungsschienen 18, 19 aufliegt und geführt ist.

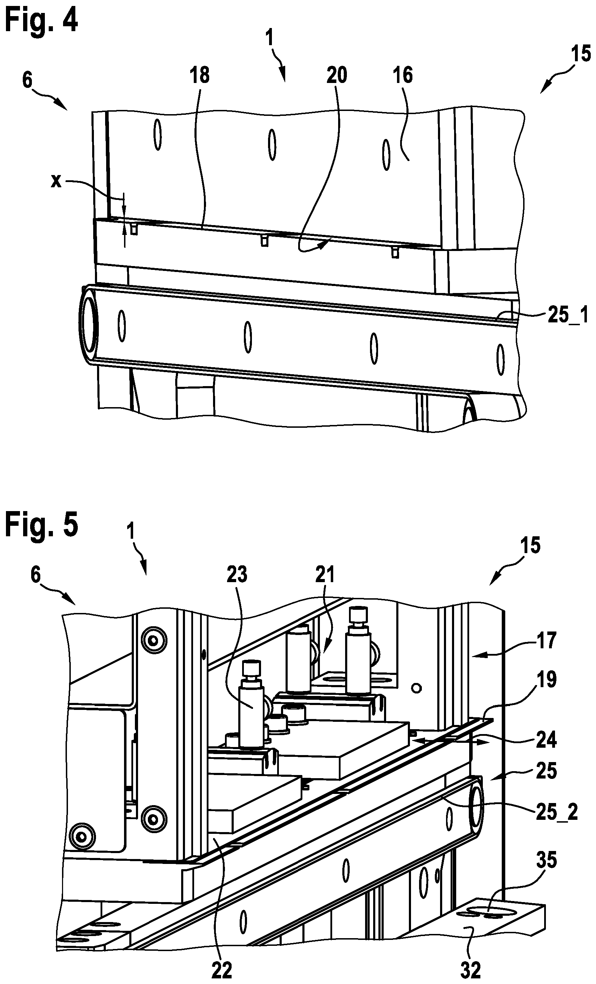

**Figur 4** zeigt eine perspektivischen Detailansicht die Vereinzelungseinrichtung 15 mit Blick auf die erste Führungswand 16. Wie in **Figur 4** gezeigt, endet die Führungswand 16 in einem Abstand x zu der Führungsschiene 18, sodass zwischen der Führungsschiene 18 und der Führungswand 16 eine Aufnahme 20 ausgebildet ist, auf die untenstehend näher eingegangen wird.

**Figur 5** zeigt die Vereinzelungseinrichtung 15 mit Blick auf die zweite Führungswand 17, wobei die zweite Führungswand 17 an dieser Stelle nicht gezeigt ist, um die dahinterliegenden Bestandteile der Vereinzelungseinrichtung 15 zu zeigen. Die Führungswand 17 endet ebenfalls in einem Abstand zu der ihr zugeordneten Führungsschiene 19, wobei der Abstand dem Abstand x entsprechen oder anders gewählt sein kann. Vorzugsweise ist der Abstand der Führungswand 17 zu der Führungsschiene 19 kleiner als die Höhe der einzelnen Substrate des aufzunehmenden oder aufgenommenen Substratstapels.

Hinter der Führungswand 17 ist eine erste Aktuatorvorrichtung 21 angeordnet. Die Aktuatorvorrichtung 21 weist ein Aktuatorelement 22 in Form einer Schiebeplatte auf, die auf der Führungsschiene 19 aufliegt und sich in deren Längserstreckung erstreckt. Weiterhin weist die Aktuatorvorrichtung 21 einen ansteuerbaren Aktuator 23 auf, der beispielsweise als elektromechanischer, hydraulischer oder pneumatischer Aktuator ausgebildet ist, um das Aktuatorelement 22 vertikal, wie durch ein Doppelpfeil 24 gezeigt, zu verschieben. Dabei ist das Aktuatorelement 22 horizontal derart verschiebbar, dass es in Richtung der gegenüberliegenden Führungswand 16 und zurück verschiebbar ist. Dabei ist das Aktuatorelement 22 derart weit verschiebbar, dass es über den Rand beziehungsweise das Ende der Führungsschiene 19 hinaus in Richtung der gegenüberliegenden Führungswand 16 verschiebbar ist.

Das Aktuatorelement 22 dient dazu, das unterste Substrat des Substratstapels, das auf der Führungsschiene 19 randseitig aufliegt, in Richtung der gegenüberliegenden Führungswand 16 beziehungsweise in die darunter ausgebildete Aufnahme 20 einzuschieben, bis das unterste Substrat über die Kante beziehungsweise das freie Ende der Führungsschiene 19 hinausgeschoben ist, sodass es von da aus optional direkt nach unten auf ein darunter liegendes Transportband 25 fällt.

Das Transportband ist gemäß diesem Ausführungsbeispiel mehrteilig ausgebildet und weist ein erstes Transportband 25_1 und ein zweites Transportband 25_2 auf. Das erste Transportband 25_1 ist dabei unterhalb der ersten Führungsschiene 18 angeordnet, wie in **Figur 4** gezeigt, und das zweite Transportband 25_2 unter der Führungsschiene 19, wie in **Figur 5** gezeigt. Das zweite Transportband 25_2 ist derart angeordnet und/oder ausgebildet, dass das unterste Substrat von der Führungsschiene 19 direkt auf das Transportband 25_2 fallen kann.

Die Schieberplatte beziehungsweise das Aktuatorelement 22 weist eine Höhe auf, die kleiner ist als der Abstand der Führungswand 17 zu der Führungsschiene 19, sodass das Aktuatorelement 22 durch den Schlitz beziehungsweise die Öffnung zwischen Führungswand 17 und Führungsschiene 19 hindurch auf den von der Führungswand 17 vorstehenden Abschnitt der Führungsschiene 19 verschiebbar ist.

Dadurch, dass das unterste Substrat des Substratstapels durch das Aktuatorelement 22 in Richtung der gegenüberliegenden Führungswand 16 geschoben wird, und weil das unterste Substrat auf der Führungsschiene 18 aufliegt, wird das unterste Substrat in die Aufnahme 20 zwischen Führungswand 16 und Führungsschiene 18 durch die Aktuatorvorrichtung 21 eingeschoben. Abstand x ist somit größer als die Höhe des Substrats zu wählen oder, bei einer bevorzugt verschiebbaren Führungswand 16, einzustellen. Dabei ist Abstand x außerdem bevorzugt kleiner als die doppelte Höhe des Substrats, sodass das darüberliegende Substrat beim Verschieben des untersten Substrats nicht mitverschoben und vielmehr durch die Führungswand 16 am Verschieben gehindert wird. Damit wird nur das unterste Substrat verschoben und von dem übrigen Substratstapel gelöst beziehungsweise vereinzelt.

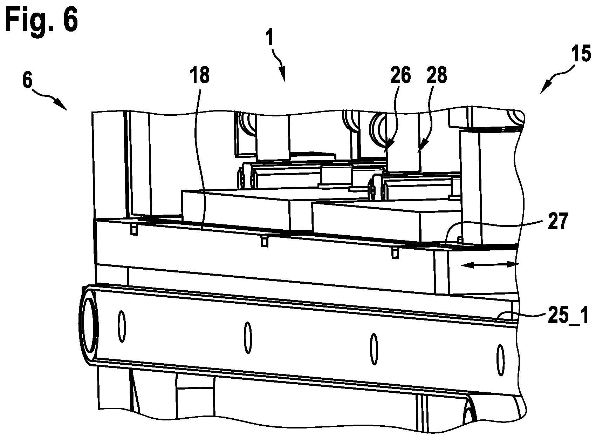

**Figur 6** zeigt eine perspektivische Detailansicht der Vereinzelungseinrichtung 15 gemäß der Darstellung von Figur 4, jedoch ohne die Führungswand 16. Auch auf dieser Seite der Vereinzelungseinrichtung 15 ist hinter der Führungswand 16 eine Aktuatorvorrichtung 26 angeordnet, die ein verschiebbares Aktuatorelement 27 und einen ansteuerbaren Aktuator 28, der insbesondere wie der Aktuator 23 ausgebildet ist, aufweist. Das Aktuatorelement 27 entspricht dem Aktuatorelement 22 und ist bevorzugt als Schiebeplatte ausgebildet, die auf der Führungsschiene 18 aufliegt und durch den Aktuator 28 vor und zurück beziehungsweise horizontal verschiebbar ist. Die jeweilige Schiebeplatte ist beispielsweise als Blechelement ausgebildet. In seiner Ausgangsstellung liegt das Aktuatorelement 27 insbesondere derart, dass es zurückversetzt zu der Führungswand 16 liegt und somit die Aufnahme 20 freigibt. Wird es von dem Aktuator 28 vorgeschoben, so wird es derart weit vorgeschoben, dass es über den Außenrand der Führungsschiene 18 in Richtung der gegenüberliegenden Führungswand 17 hinausverschoben wird. Ist zuvor das unterste Substrat in die Aufnahme 20 eingeschoben worden, so wird es nun durch das Führungselement 27 aus der Aufnahme 20 wieder herausgeschoben und über den durch die Führungsschiene 18 gebildeten Vorsprung hinausgeschoben, sodass auch an dieser Seite das Substrat von der Führungsschiene 18 herunter in Richtung des Transportbandes 25 beziehungsweise 25_1 fällt. Anschließend liegt das unterste Substrat nunmehr vollständig auf dem Transportband 25 und kann damit weitertransportiert werden, um der Bestückungslinie zugeführt werden zu können. Nun wird das Verfahren wiederholt und das nun zu unterst liegende Substrat, dass jetzt das unterste Substrat des Substratstapels ausbildet, wird wie zuvor beschrieben vereinzelt.

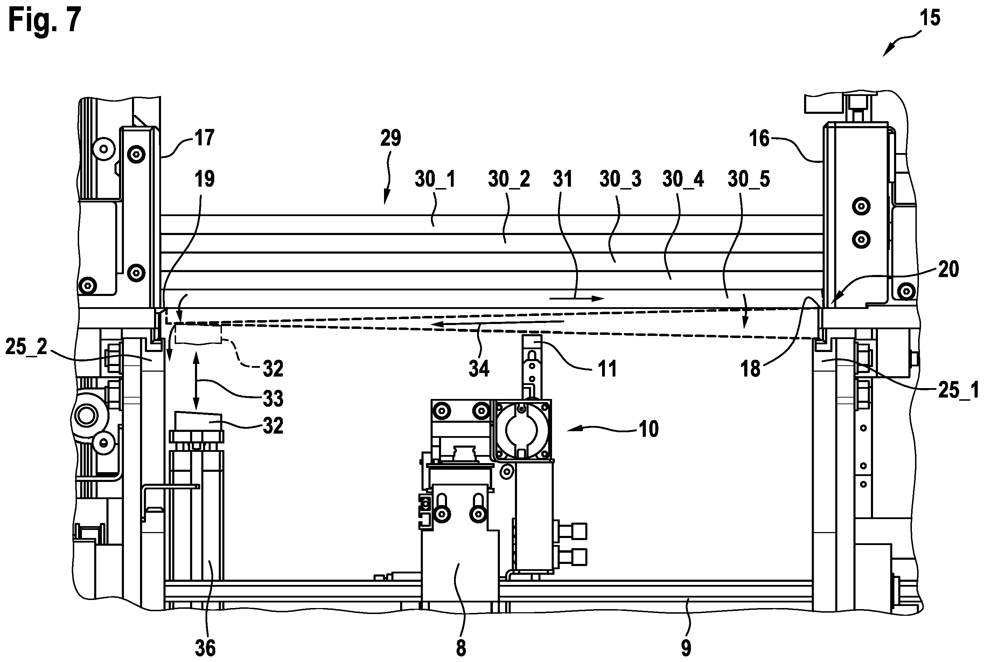

In **Figur 7** ist dieser Vorgang vereinfacht anhand eines Substratstapels 29 gezeigt, der in die Vereinzelungseinrichtung 15 durch den Greifarm 11 eingeschoben geschoben wurde.

Der Substratstapel 29 weist gemäß dem vorliegenden Ausführungsbeispiel fünf Substrate 30_1, 30_2, 30_3, 30_4 und 30_5 auf. Das unterste Substrat 30_5 liegt auf den Führungsschienen 18, 19 randseitig auf. Im Übrigen liegt die Unterseite des untersten Substrats 30_5 frei. Die Substrate 30_1 bis 30_5 werden seitlich durch die Führungswände 16 und 17 ausgerichtet und gehalten. Nachdem der Substratstapel 29 in die Vereinzelungseinrichtung 15 eingeführt wurde, wird der Greifarm 10 in seiner Ausgangslage zurück nach unten gefahren, sodass zwischen dem Greifarm 10 und dem Substratstapel 29 ein Abstand verbleibt. Insbesondere wird der Greifarm 10 derart weit nach unten bewegt, dass er unterhalb der Transportebene des Transportbandes 25 liegt.

Anschließend wird das unterste Substrat 30_5 durch die erste Aktuatorvorrichtung 21 in die Aufnahme 20 geschoben, wie durch einen Pfeil 31 gezeigt. Sobald das Substrat 30_5 aus die Führungsschiene 19 hinausgeschoben wurde, fällt das Substrat 30_5 an der im Bild linken Seite nach unten in Richtung des Transportbands 25_2.

Um die Fallhöhe zu reduzieren, ist vorzugsweise eine Stützschiene 32 vorhanden, die insbesondere durch einen Pneumatik-, Hydraulik- oder elektromechanischen Zylinder 36 in ihrer Höhe verstellbar ist. Insbesondere wird die Stützschiene 32 nach oben bewegt, wie durch einen Pfeil 33 gezeigt, insbesondere noch bevor das erste Substrat 30_5 in die Aufnahme 20 geschoben wird. In dieser Annahmeposition liegt die Stützschiene 32 in einer Höhe zwischen der Transportebene des Transportbandes 25 und der Führungsschiene 19. Das Substrat 30_5 fällt somit links zunächst auf die Stützschiene 32 und wird durch diese gehalten, wie in **Figur 7** durch eine gestrichelte Linie des Substrats 30_5 angedeutet. Anschließend wird das Substrat 30_5 durch die zweite Aktuatorvorrichtung in die entgegengesetzte Richtung zurückgeschoben, wie durch einen Pfeil 34 angezeigt, sodass das Substrat und 30_5 auch an einer rechten Seite von Führungsschiene 18 herunterfällt. In diesem Fall fällt das Substrat 30_5 direkt auf das Transportband 25_1. Nunmehr liegt das Substrat 30_5 erneut gekippt einerseits auf der Stützschiene 32 und andererseits auf den Transportband 25_1 auf. Anschließend wird die Stützschiene 32 nach unten bewegt in ihre Ausgangsstellung, in welcher sie unterhalb der Transportebene liegt. Dadurch legt die Stützschiene 32 das Substrat 30_5 auf das Transportband 25_2 ab, und das Substrat 30_5 ist vollständig von dem Substratstapel 29 gelöst und kann durch das Transportband 25 zur weiteren Verwendung weitertransportiert werden.

Vorzugsweise ist beispielsweise der Führungsschiene 19 ein Sensor zugeordnet, der berührungsfrei, insbesondere optisch, erfasst, ob sich ein Substratstapel 29 in der Vereinzelungseinrichtung 15 an der gewünschten Stelle befindet. Beispielsweise ist der Sensor 35 an der Stützschiene 23 oder dem Greifarm 10 angeordnet, wie in **Figur 3** beispielhaft gezeigt.

Durch die vorteilhafte Entladeeinrichtung 6 wird erreicht, dass auf kleinem Bauraum eine vorteilhafte Vereinzelung von Substratstapeln erfolgen kann. Gleichzeitig kann die Entladeeinrichtung auch dazu genutzt werden, einzelne Substrate aus dem jeweiligen Magazin 3, 4, 5 zu entnehmen. Somit ist die Entladeeinrichtung vielseitig einsetzbar.

## Patentansprüche

1. Entladeeinrichtung für ein Substratmagazin, wobei das Substratmagazin (3,4,5) mehrere Schubfächer (7) aufweist, in welchen Substrate zur Lagerung oder Zwischenlagerung anordenbar sind, mit zumindest einem ansteuerbaren Transportband (25), auf welchem Substrate ablegbar sind, und mit zumindest einem ansteuerbaren Greifarm (10), der dazu ausgebildet ist, zumindest ein Substrat aus einem Schubfach des Substratmagazins (3,4,5) zu dem Transportband (25) herauszuschieben, wobei das Transportband (25) und der Greifarm (10) an einem gemeinsamen und beweglich gelagerten Träger (8) angeordnet sind, wobei der Greifarm (10) zumindest in einer Ausgangsstellung unterhalb des Transportbands (25) angeordnet ist, um zumindest ein Substrat von unten zum Herausschieben zu greifen, **dadurch gekennzeichnet, dass** der Greifarm (10) dazu ausgebildet ist, einen Substratstapel (29) mit mehrere aufeinanderliegenden Substraten (30_1-30_5) aus einem der Schubfächer (7) oberhalb des Transportbandes (25) herzauszuschieben, dass oberhalb des Transportbandes (25) eine Vereinzelungseinrichtung (15) angeordnet ist, in welche der Substratstapel (29) durch den Greifarm (10) einschiebbar ist, und dass die Vereinzelungseinrichtung (15) dazu ausgebildet ist, das unterste Substrat (30_5) des Substratstapels (29) von dem Substratstapel (29) zu lösen und auf das darunterliegende Transportband (25) abzulegen.

2. Entladeeinrichtung Anspruch 1, **dadurch gekennzeichnet, dass** die Vereinzelungseinrichtung (15) zwei beabstandet zueinander angeordnete Führungswände (16, 17) aufweist, zwischen denen der Substratstapel (29) vertikal geführt aufnehmbar ist.

3. Entladeeinrichtung nach einem der vorhergehenden Ansprüche, **dadurch gekennzeichnet, dass** dem unteren Ende der Führungswände (16, 17) zwei beabstandet und parallel zueinander angeordnete Führungsschienen (18, 19) zugeordnet sind, auf welchen ein Substratstapel (29) derart zwischen den Führungswänden (16, 17) aufschiebbar ist, dass das unterste Substrat (30_5) des Substratstapels (29) an zwei voneinander abgewandten Seitenrändern auf jeweils einer der Führungsschienen (18, 19) aufliegt.

4. Entladeeinrichtung nach einem der vorhergehenden Ansprüche, **dadurch gekennzeichnet, dass** eine erste der Führungswände (16, 17) in einem Abstand (x) zu der ihr zugeordneten ersten Führungsschiene (18, 19) endet, der zumindest der Höhe des untersten Substrats entspricht, so dass das unterste Substrat in eine durch den Abstand (x) gebildete Aufnahme (20) zwischen erster Führungswand (16) und erster Führungsschiene (18) einschiebbar ist.

5. Entladeeinrichtung nach einem der vorhergehenden Ansprüche, **dadurch gekennzeichnet, dass** die Tiefe der Aufnahme (20) mindestens der Breite der zweiten Führungsschiene (19) vor der zweiten Führungswand (17) entspricht.

6. Entladeeinrichtung nach einem der vorhergehenden Ansprüche, **dadurch gekennzeichnet, dass** die Vereinzelungseinrichtung (15) eine erste Aktuatorvorrichtung (21) aufweist, die dazu ausgebildet ist, das unterste Substrat (30_5) in die Aufnahme (20) und über die (zweite) Führungsschiene (19) hinaus einzuschieben.

7. Entladeeinrichtung nach einem der vorhergehenden Ansprüche, **dadurch gekennzeichnet, dass** die Vereinzelungseinrichtung (15) eine zweite Aktuatorvorrichtung (26) aufweist, die dazu ausgebildet ist, das unterste Substrat (30_5) aus der Ausnahme (20) und über die erste Führungsschiene (18) hinaus zu schieben.

8. Entladeeinrichtung nach einem der vorhergehenden Ansprüche, **dadurch gekennzeichnet, dass** unter den Führungsschienen (18, 19) das zumindest eine Transportband (25) in einem Abstand angeordnet ist, der größer als die Höhe des untersten Substrats (30_5) ist.

9. Entladeeinrichtung nach einem der vorhergehenden Ansprüche, **dadurch gekennzeichnet, dass** die Vereinzelungseinrichtung (15) derart ausgebildet ist, dass das unterste Substrat (30_5) durch das Verschieben mittels der ersten und/oder zweiten Aktuatorvorrichtung (21,26) direkt auf das zumindest eine Transportband (25) fällt.

10. Entladeeinrichtung nach einem der vorhergehenden Ansprüche, **dadurch gekennzeichnet, dass** zwei Transportbänder (25_1, 25_2) parallel und beabstandet zueinander angeordnet sind, wobei jeweils eines der Transportbänder einer der Führungsschiene (18, 19) zugeordnet ist.

11. Entladeeinrichtung nach einem der vorhergehenden Ansprüche, **dadurch gekennzeichnet, dass** an dem Träger (8) zumindest eine Stützschiene (32) angeordnet und in der Höhe verfahrbar ist, um zwischen den Führungsschienen (18, 19) in einer Annahmestellung oberhalb der Transportebene des jeweiligen Transportbands (25_1, 25_2) und unterhalb der Führungsschienen (18, 19) zu liegen, so dass das unterste Substrat auf die Stützschiene (32) fällt, und in einer Ablagestellung unterhalb der Transportebene.

12. Entladeeinrichtung nach einem der vorhergehenden Ansprüche, **dadurch gekennzeichnet, dass** der Träger (8) in der Höhe verfahrbar ausgebildet ist.

13. Entladeeinrichtung nach einem der vorhergehenden Ansprüche, **dadurch gekennzeichnet, dass** die zumindest eine Stützschiene (32) der zweiten Führungsschiene (19) zugeordnet ist.

14. Substratmagazinsystem (1) für eine Bearbeitungslinie, insbesondere Bestückungslinie, von flächigen Substraten, mit zumindest einem Substratmagazin (3,4,5), das mehrere Schubfächer (7) aufweist, in welchen mehrere Substrate und/oder Substratstapel (29) zur Lagerung oder Zwischenlagerung anordenbar sind, **gekennzeichnet durch** eine Entladeeinrichtung (6) gemäß einem der Ansprüche 1 bis 13.

## Claims

1. Discharging device for a substrate magazine, wherein the substrate magazine (3,4,5) comprises multiple drawers (7) in which substrates are arrangeable for storage or temporary storage, with at least one controllable conveyor belt (25) on which substrates can be placed, and with at least one controllable gripper arm (10), which is designed to push at least one substrate out of a drawer of the substrate magazine (3,4,5) to the conveyor belt (25), wherein the conveyor belt (25) and the gripper arm (10) are arranged on a common and movably mounted carrier (8), wherein the gripper arm (10) is arranged, at least in a starting position, below the conveyor belt (25) in order to grip at least one substrate from below for pushing out, **characterized in that** the gripper arm (10) is designed to push a substrate stack (29) with multiple substrates (30_1-30_5) lying one on top of another out of one of the drawers (7) above the conveyor belt (25), **in that** a separating device (15) is arranged above the conveyor belt (25), into which the substrate stack (29) is insertable by the gripper arm (10), and **in that** the separating device (15) is designed to release the lowest substrate (30_5) of the substrate stack (29) from the substrate stack (29) and deposit it on the underlying conveyor belt (25).

2. Discharging device claim 1, **characterized in that** the separating device (15) comprises two guide walls (16, 17) arranged spaced apart from one another, between which the substrate stack (29) is receivable in a vertically guided manner.

3. Discharging device according to any one of the preceding claims, **characterized in that** the lower end of the guide walls (16, 17) is assigned two guide rails (18, 19) arranged spaced apart and parallel to one another, on which a substrate stack (29) can be pushed between the guide walls (16, 17) so that the lowest substrate (30_5) of the substrate stack (29) rests on two side edges facing away from one another on one of the guide rails (18, 19) in each case.

4. Discharging device according to any one of the preceding claims, **characterized in that** a first of the guide walls (16, 17) ends at a distance (x) from the first guide rail (18, 19) assigned thereto, which corresponds at least to the height of the lowest substrate, so that the lowest substrate is insertable into a receptacle (20) formed by the distance (x) between the first guide wall (16) and the first guide rail (18).

5. Discharging device according to any one of the preceding claims, **characterized in that** the depth of the receptacle (20) corresponds at least to the width of the second guide rail (19) in front of the second guide wall (17).

6. Discharging device according to any one of the preceding claims, **characterized in that** the separating device (15) comprises a first actuator device (21) which is designed to insert the lowest substrate (30_5) into the receptacle (20) and over the (second) guide rail (19).

7. Discharging device according to any one of the preceding claims, **characterized in that** the separating device (15) comprises a second actuator device (26) which is designed to push the lowest substrate (30_5) out of the receptacle (20) and over the first guide rail (18).

8. Discharging device according to any one of the preceding claims, **characterized in that** the at least one conveyor belt (25) is arranged under the guide rails (18, 19) at a distance which is greater than the height of the lowest substrate (30_5).

9. Discharging device according to any one of the preceding claims, **characterized in that** the separating device (15) is designed such that the lowest substrate (30_5) falls directly onto the at least one conveyor belt (25) due to the displacement by means of the first and/or second actuator device (21,26).

10. Discharging device according to any one of the preceding claims, **characterized in that** two conveyor belts (25_1, 25_2) are arranged in parallel and spaced apart from one another, wherein one of the conveyor belts is assigned to each one of the guide rails (18, 19).

11. Discharging device according to any one of the preceding claims, **characterized in that** at least one support rail (32) is arranged on the carrier (8) and is movable in height in order to lie between the guide rails (18, 19) in a receiving position above the transport level of the respective conveyor belt (25_1, 25_2) and below the guide rails (18, 19), so that the lowest substrate falls onto the support rail (32), and in a depositing position below the transport level.

12. Discharging device according to any one of the preceding claims, **characterized in that** the carrier (8) is designed to be movable in height.

13. Discharging device according to any one of the preceding claims, **characterized in that** the at least one support rail (32) is assigned to the second guide rail (19).

14. Substrate magazine system (1) for a processing line, in particular assembly line, of planar substrates, with at least one substrate magazine (3, 4, 5) which comprises multiple drawers (7) in which multiple substrates and/or substrate stacks (29) are arrangeable for storage or intermediate storage, **characterized by** a discharging device (6) according to any one of claims 1 to 13.

## Revendications

1. Dispositif de déchargement pour un magasin de substrats, dans lequel le magasin de substrats (3, 4, 5) comprend plusieurs tiroirs (7) dans lesquels des substrats peuvent être disposés pour le stockage ou l'entreposage, avec au moins une bande transporteuse (25) commandable sur laquelle des substrats peuvent être déposés, et avec au moins un bras de préhension (10) commandable qui est conçu pour pousser au moins un substrat hors d'un tiroir du magasin de substrats (3, 4, 5) vers la bande transporteuse (25), dans lequel la bande transporteuse (25) et le bras de préhension (10) sont disposés sur un support (8) commun, monté de manière mobile, dans lequel le bras de préhension (10) est disposé au moins dans une position initiale sous la bande transporteuse (25) afin de saisir au moins un substrat à partir du bas pour le pousser, **caractérisé en ce que** le bras de préhension (10) est conçu pour pousser une pile de substrats (29) composée de plusieurs substrats (30_1-30_5) empilés les uns sur les autres, hors de l'un des tiroirs (7) au-dessus de la bande transporteuse (25), en qu'un dispositif de séparation (15) est disposé au-dessus de la bande transporteuse (25), dans lequel la pile de substrats (29) peut être insérée par le bras de préhension (10), et **en ce que** le dispositif de séparation (15) est conçu pour séparer le substrat le plus bas (30_5) de la pile de substrats (29) et le déposer sur la bande transporteuse (25) située en dessous.

2. Dispositif de déchargement selon la revendication 1, **caractérisé en ce que** le dispositif de séparation (15) comprend deux parois de guidage (16, 17) espacées l'une de l'autre, entre lesquelles la pile de substrats (29) peut être réceptionnée et guidée verticalement.

3. Dispositif de déchargement selon l'une des revendications précédentes, **caractérisé en ce que** deux rails de guidage (18, 19) espacés et parallèles l'un à l'autre sont associés à l'extrémité inférieure des parois de guidage (16, 17), sur lesquels une pile de substrats (29) peut être glissée entre les parois de guidage (16, 17) de sorte que le substrat le plus bas (30_5) de la pile de substrats (29) repose sur deux bords latéraux opposés sur respectivement l'un des rails de guidage (18, 19).

4. Dispositif de déchargement selon l'une des revendications précédentes, **caractérisé en ce qu'**une première des parois de guidage (16, 17) se termine à un écart (x) par rapport au premier rail de guidage (18, 19) qui lui est associé, qui correspond au moins à la hauteur du substrat le plus bas, de sorte que le substrat le plus bas puisse être poussé dans un logement (20) formé par l'écart (x) entre la première paroi de guidage (16) et le premier rail de guidage (18).

5. Dispositif de déchargement selon l'une des revendications précédentes, **caractérisé en ce que** la profondeur du logement (20) correspond au moins à la largeur du deuxième rail de guidage (19) devant la deuxième paroi de guidage (17).

6. Dispositif de déchargement selon l'une des revendications précédentes, **caractérisé en ce que** le dispositif de séparation (15) comprend un premier dispositif d'actionnement (21) qui est conçu pour pousser le substrat le plus bas (30_5) dans le logement (20) et au-delà du (deuxième) rail de guidage (19).

7. Dispositif de déchargement selon l'une des revendications précédentes, **caractérisé en ce que** le dispositif de séparation (15) comprend un deuxième dispositif d'actionnement (26) qui est conçu pour pousser le substrat le plus bas (30_5) hors du logement (20) et au-delà du premier rail de guidage (18).

8. Dispositif de déchargement selon l'une des revendications précédentes, **caractérisé en ce que,** sous les rails de guidage (18, 19), l'au moins une bande transporteuse (25) est disposée à une distance qui est supérieure à la hauteur du substrat le plus bas (30_5).

9. Dispositif de déchargement selon l'une des revendications précédentes, **caractérisé en ce que** le dispositif de séparation (15) est conçu de sorte que le substrat le plus bas (30_5) tombe directement sur l'au moins une bande transporteuse (25) grâce à la poussée effectuée par le premier et/ou le deuxième dispositif d'actionnement (21, 26).

10. Dispositif de déchargement selon l'une des revendications précédentes, **caractérisé en ce que** deux bandes transporteuses (25_1, 25_2) sont disposées parallèlement et à distance l'une de l'autre, dans lequel chacune des bandes transporteuses est associée à l'un des rails de guidage (18, 19).

11. Dispositif de déchargement selon l'une des revendications précédentes, **caractérisé en ce qu'**au moins un rail de support (32) est disposé sur le support (8) et peut être déplacé en hauteur afin de se trouver entre les rails de guidage (18, 19) dans une position de réception au-dessus du plan de transport de la bande transporteuse (25_1, 25_2) respective et en dessous des rails de guidage (18, 19), de sorte que le substrat le plus bas tombe sur le rail de support (32), et dans une position de remise en dessous du plan de transport.

12. Dispositif de déchargement selon l'une des revendications précédentes, **caractérisé en ce que** le support (8) est conçu de manière à pouvoir être déplacé en hauteur.

13. Dispositif de déchargement selon l'une des revendications précédentes, **caractérisé en ce qu'**au moins un rail de support (32) est associé au deuxième rail de guidage (19).

14. Système de magasin de substrats (1) pour une ligne d'usinage, en particulier une ligne d'équipement, de substrats plats, comprenant au moins un magasin de substrats (3, 4, 5) qui présente plusieurs tiroirs (7) dans lesquels plusieurs substrats et/ou piles de substrats (29) peuvent être disposés pour le stockage ou l'entreposage, **caractérisé par** un dispositif de déchargement (6) selon l'une des revendications 1 à 13.
